Europäisches Patentamt

European Patent Office

Office européen des brevets

(11) Publication number: **0 020 113**
**A1**

## (12) EUROPEAN PATENT APPLICATION

(21) Application number: **80301730.0**

(22) Date of filing: **23.05.80**

(51) Int. Cl.³: **H 01 L 27/06,** H 01 L 27/10,
G 11 C 11/40

(30) Priority: **04.06.79 JP 69796/79**

(43) Date of publication of application: **10.12.80**
**Bulletin 80/25**

(84) Designated Contracting States: **DE FR GB NL**

(71) Applicant: **FUJITSU LIMITED, 1015, Kamikodanaka**
**Nakahara-ku, Kawasaki-shi Kanagawa 211 (JP)**

(72) Inventor: **Itoh, Hideo, 1726, Kamikodanaka Nakahara-ku,**
**Kawasaki-shi Kanagawa 211 (JP)**
Inventor: **Noguchi, Eiji, 2-10-3, Wakabadai**
**Shiroyama-machi, Tsukui-gun Kanagawa 220-01 (JP)**

(74) Representative: **Ailman, Peter John et al, Marks and**
**Clerk, Scottish Life House Bridge Street, Manchester**
**M3 3DP (GB)**

(54) **Semiconductor device.**

(57) In a semiconductor device comprising one or more driver transistors (Qn1) and (Qn2) one or more load elements (61, 62) each of which is connected to one of the driver transistors, respectively, each of the driver transistors is composed of an MIS transistor formed on a first conductivity type semiconductor region (2) which is formed on a second conductivity type semiconductor substrate (1), and each of the load elements is composed of a reverse biased pn junction which is formed on the second conductivity type semiconductor substrate.

# SEMICONDUCTOR DEVICE

## BACKGROUND OF THE INVENTION

### (1)   Field of the Invention

The present invention relates to a semiconductor device, more particularly to a metal-insulator-semiconductor (hereinafter referred to as an MIS) integrated circuit device, such as an MIS memory device used in an electronic computer.

### (2)   Description of the Prior Art

In recent years, a large scale integrated circuit, such as a random access memory device, has been manufactured by using MIS technology.  This is because the MIS integrated circuit has a simple structure and can be manufactured by a simple manufacturing process, so that the MIS integrated circuit is quite suitable for large scale integration. However, since the area occupied by MIS Field Effect transistors and load elements of the MIS Field Effect transistors in MIS integrated circuit is relatively large, the chip size of the MIS integrated circuit increases greatly according to the increase of degree of integration, so that the probability of defects in the chip becomes large and, consequently, the production yield of the MIS integrated circuits becomes low.

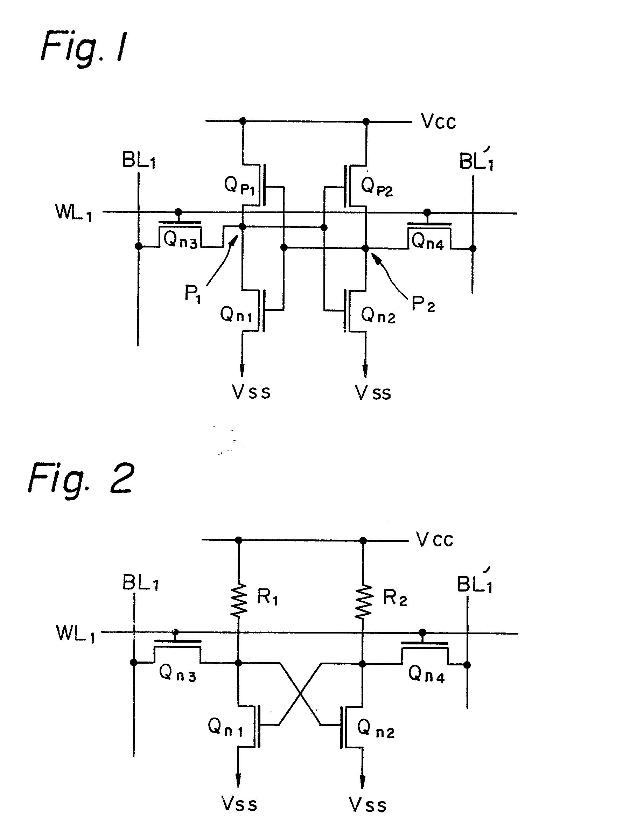

For example, a complementary MIS (hereinafter referred to as a CMIS) memory cell which is used in a conventional CMIS random access memory comprises, as illustrated in Fig. 1, two n-channel type transistors $Q_{n1}$ and $Q_{n2}$ which are driver transistors, two p-channel type transistors $Q_{p1}$ and $Q_{p2}$ which are load transistors of the driver transistors $Q_{n1}$ and $Q_{n2}$ respectively, and two n-channel type transistors $Q_{n3}$ and $Q_{n4}$ which are gate transistors.  The gate electrodes of the gate transistors $Q_{n3}$ and $Q_{n4}$ are connected to a word line $WL_1$ , and the source electrodes of the gate transistors $Q_{n3}$ and $Q_{n4}$ are connected to bit lines $BL_1$ and $BL_1'$ , respectively.  In Fig. 1, for example, the logic "1" state of the memory cell corresponds to the state wherein the potentials at $P_1$ and $P_2$ are low and high, respectively, i.e., the MIS transistors $Q_{n1}$ and $Q_{p2}$ are conductive and the MIS transistors $Q_{p1}$ and $Q_{n2}$ are non-conductive. Similarly, the logic "0" state of the memory cell of Fig. 1 corresponds to the state wherein the potentials at $P_1$ and $P_2$ are high and low, respectively, i.e., the MIS transistors $Q_{p1}$ and $Q_{n2}$ are conductive and the MIS transistors $Q_{n1}$ and $Q_{p2}$ are non-conductive. The access operation of this memory cell is well known, and the explanation thereof is omitted herein.

Since the memory cell of Fig. 1 uses six MIS transistors, including both n-channel MIS transistors and p-channel MIS transistors, the cell size thereof is relatively large. Therefore, it is difficult to make a large capacity memory device by using the memory cells of Fig. 1.

Fig. 2 illustrates an n-channel type MIS memory cell which is used in a conventional MIS random access memory. The structure of the memory cell of Fig. 2 is the same as that of the memory cell of Fig. 1, except that the load transistors $Q_{p1}$ and $Q_{p2}$ of Fig. 1 are replaced by high resistance load elements $R_1$ and $R_2$ , which are made of polycrystalline silicon. Each of the high resistance load elements $R_1$ and $R_2$ can be formed in a smaller area on the MIS integrated circuit than that of the transistor $Q_{p1}$ or $Q_{p2}$ of the memory cell of Fig. 1. However, the area occupied by the high resistance element is not sufficiently small for making the chip size so small that a high productivity of the MIS memory device is attained. Moreover, the high resistance element must be formed through a different manufacturing process from the process of making other polycrystalline silicon conductive layers, so that the manufacturing process of the MIS memory device becomes complicated.

In order to reduce the area occupied by each of the load elements of the MIS transistors of an MIS integrated circuit, an MIS integrated circuit is disclosed in Japanese Patent Application Laid-Open No. 53-39087 in which the load element of the MIS transistor consists of a substrate of the MIS integrated circuit and a barrier formed between a drain region of the MIS transistor and the substrate. However, this prior art MIS integrated circuit has a complicated structure and, therefore, the manufacturing process thereof is not simple.

SUMMARY OF THE INVENTION

It is the principal object of the present invention to reduce the area occupied by the load element of the MIS transistor in the MIS integrated circuit, such as an MIS memory device, so that the degree of integration of the MIS integrated circuit can be increased.

It is another object of the present invention to provide an MIS integrated circuit having high-density integration which can be manufactured through a very simple manufacturing process.

According to the present invention, there is provided an MIS integrated circuit device compirising one or more driver transistors and one or more load elements each of which is connected to one of the driver transistors respectively, characterized in that each of the driver transistors is composed of an MIS transistor formed on a semiconductor substrate portion, and each of the load elements is composed of a reverse biased pn junction which is formed on the semiconductor substrate portion.

The present invention will be more clearly understood from the following description with reference to the accompanying drawings.

BRIEF DESCRIPTION OF THE DRAWINGS

Fig. 1 is a circuit diagram illustrating a conventional CMIS memory cell used in a conventional CMIS random access memory device.

Fig. 2 is a circuit diagram illustrating a conventional n-channel type MIS memory cell used in a conventional MIS random access memory device.

Fig. 3 is a cross sectional view illustrating an MIS memory cell, as an embodiment of the present invention.

Figs. 4, 5 and 6 are partial cross sectional views illustrating a manufacturing process of the MIS memory cell of Fig. 3.

Fig. 7 is a cross sectional view illustrating an MIS transistor and a load thereof, as another embodiment of the present invention.

DESCRIPTION OF THE PREFERRED EMBODIMENTS

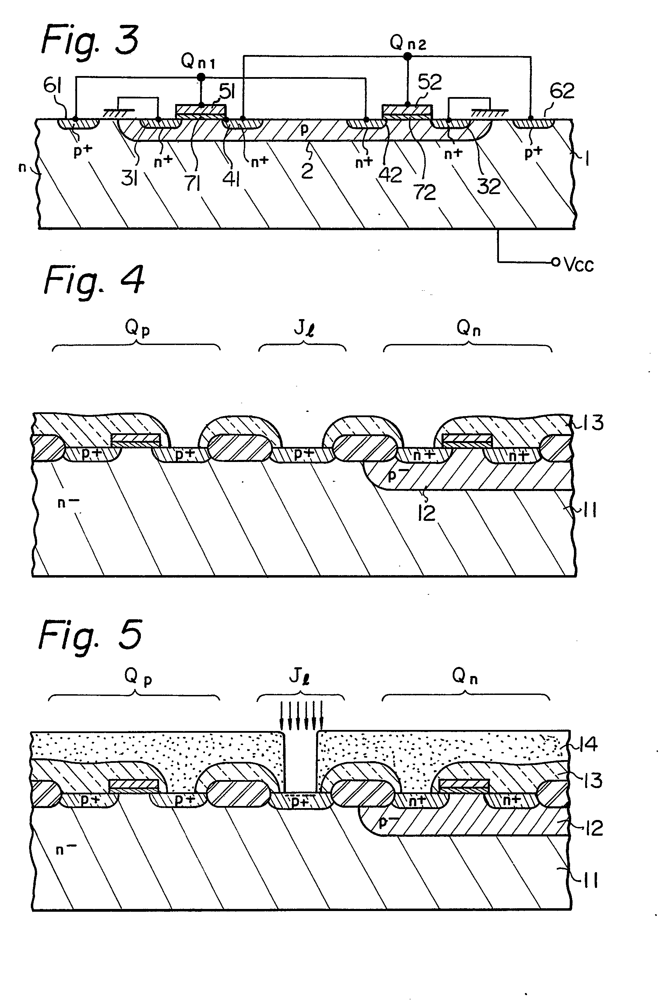

Fig. 3 illustrates a structure of an MIS memory cell according to the present invention. The memory cell of Fig. 3 is formed by using CMIS technology, although the memory cell of Fig. 3 contains only one type of an MIS transistor, for example n-type MIS transistors $Q_{n1}$ and $Q_{n2}$. Therefore, it is possible to use the memory cell of Fig. 3 in a CMIS memory device in which peripheral circuits, such as address buffers, are constructed by CMIS circuits. In Fig. 3, on the surface of a p type well 2 which is formed on an n type silicon semiconductor substrate 1, two n-channel type driver transistors $Q_{n1}$ and $Q_{n2}$ are formed. The transistors $Q_{n1}$ and $Q_{n2}$ respectively comprise $n^+$ type source regions 31 and 32, $n^+$ type drain regions 41 and 42, thin insulator layers 71 and 72 made of silicon dioxide ($SiO_2$), and gate electrodes 51 and 52 which are formed on the insulator layers 71 and 72 respectively. On the n type silicon semiconductor substrate 1, $p^+$ type load regions 61 and 62 are formed. The n type silicon semiconductor substrate 1 is made of silicon having resistivity of 1 through 10 $\Omega$ cm. Impurity concentration of each of the $n^+$ type load regions 61 and 62 is about $10^{20}/cm^3$. Resistivity of n type silicon semiconductor substrate 1 can be about 50 $\Omega$ cm in order to attain appropriate withstand voltage between the n type silicon semiconductor substrate 1 and the p type well 2.

The $n^+$ type source regions 31 and 32 are both connected to the ground, the $n^+$ type drain region 41 is connected to the gate electrode 52 and to the $p^+$ type load region 62, and the $n^+$ type drain region 42 is connected to the gate electrode 51 and to the $p^+$ type load region 61.  These
connections are performed through conductive layers made,
for example, of aluminum.  In Fig. 3, the conductive
layers are illustrated diagrammatically by connection
lines, and detailed illustrations thereof are omitted.

The gate transistors $Q_{n3}$ and $Q_{n4}$ are also formed on
the p type well 2 in a similar manner to the driver tran-
sistors $Q_{n1}$ and $Q_{n2}$ , and are connected to the driver
transistors $Q_{n1}$ and $Q_{n2}$.  In Fig. 3, illustrations of the
gate transistors $Q_{n3}$ and $Q_{n4}$ are omitted.

In the above-mentioned embodiment, the $p^+$ type load
regions 61 and 62 form, with n type silicon semiconductor
substrate 1, incomplete pn junctions whose leak current,
i.e., backward current, is relatively large.  The n type
silicon semicondcutor substrate 1 is connected to the
positive voltage source $V_{cc}$.  Therefore, these pn junctions
serve as load resistors of the driver transistors $Q_{n1}$
and $Q_{n2}$.  Consequently, an equivalent circuit of the
structure of Fig. 3 is equal to the circuit of Fig. 2,
except that the n-type gate transistors $Q_{n3}$ and $Q_{n4}$ of
Fig. 2 are not included.  In the structure of Fig. 3, the
backward resistors of the pn junctions formed by the
$p^+$ type load region 61 and the n type substrate 1 and by
the $p^+$ type load region 62 and the n type substrate 1
correspond to the resistors $R_1$ and $R_2$ of Fig. 2, res-
pectively.

It is quite easy to make the incomplete, i.e., leaky,
pn junctions by the $p^+$ type load regions 61, 62 and the
n type substrate 1.  For example, it is done by implanting
impurity ions to the $p^+$ type load regions 61, 62 and then
annealing the chip.  In order to make the pn junction
whose leak current is about several nanoamperes, which is
necessary for the operation of the memory cell, annealing
temperature and time are controlled to be the appropriate
values.

It will be understood that, in the above-mentioned
embodiment of Fig. 3, the areas occupied by the $p^+$ type load regions 61 and 62 are much smaller than the areas required for forming the p-channel type MIS load transistors $Q_{p1}$ and $Q_{p2}$ of the memory cell illustrated in Fig. 1, and the manufacturing process of the above-mentioned pn junctions is much simpler than that of the p-channel type MIS load transistors $Q_{p1}$ and $Q_{p2}$. When compared with the memory cell of Fig. 2, which has the polycrystalline silicon high resistance load elements, the area occupied by the memory cell of Fig. 3 is smaller than that of the memory cell of Fig. 2, and the manufacturing process of the memory cell of Fig. 3 is simpler than that of the memory cell of Fig. 2. This is because, in the memory cell of Fig. 2, the polycrystalline silicon load resistors $R_1$ and $R_2$ must be connected to the voltage source $V_{cc}$ through conductive layers formed on the substrate, while, in the memory cell of Fig. 3, the aforementioned pn junctions are formed by the $p^+$ type load regions 61, 62 and the n type silicon substrate 1, which is connected to the voltage source $V_{cc}$, so that it is not necessary to form conductive layers connecting between the pn junctions and the voltage source $V_{cc}$.

With reference to Figs. 4 through 6, the manufacturing process of the CMIS memory device which uses the MIS memroy cell of Fig. 3, according to the present invention, will now be explained. In the following explanation, the process of forming the leaky pn junction will be mainly explained.

(1) As illustrated in Fig. 4, one of the n-channel type MIS transistors $Q_n$ of the memory cell of Fig. 3, a $p^+$ type load region $J_\ell$ constituting the pn junction with the $n^-$ type silicon semiconductor substrate 11, and a p-channel type MIS transistor $Q_p$ of another circuit, such as address buffer circuit, are formed on the substrate 11, by using the well known CMIS technology. In Fig. 4, the n-channel type transistor $Q_n$ is formed on the $p^-$ type well 12 which is formed on the $n^-$ type substrate 11. The reference numeral 13 shows a first insulating layer made of PSG (Phospho-silicate Glass) having apertures used for contacting electrodes, which apertures are formed by using the well known photolithography technology. The surface of the first insulating layer 13 is then smoothed, as illustrated in Fig. 4, by heat treatment.

(2)  A photoresist film 14 is formed on the surface of the device illustrated in Fig. 4, and a window is formed on the load region $J_\ell$ by using photolithography technology, as illustrated in Fig. 5.

(3)  Impurity ions, for example Boron ions ($B^+$), are implanted in the load region $J_\ell$ by means of the well known ion implantation method. In this case, the dose of the Boron ion is selected to be, for example, in $0.5 \times 10^{15}$ through $1 \times 10^{15}$ $[cm^{-2}]$, and the acceleration energy of the Boron ion is selected to be, for example, 100 [KeV].

(4)  The implanted impurity ions are activated by means of heat treatment on the condition, for example, that the heating temperature is 500[°C] and the heating time is 30 [minutes].

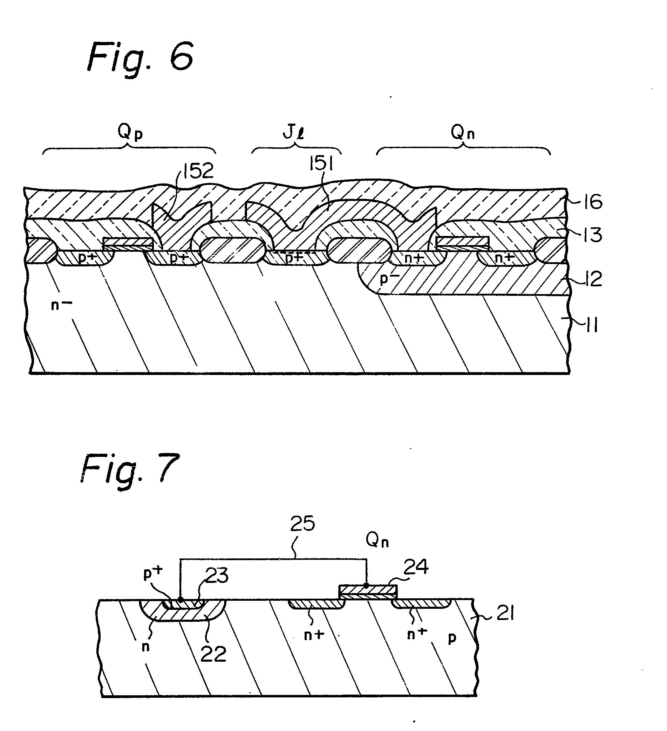

(5)  After removing the photoresist film 14, conductive layers 151 and 152 of, for example, aluminum are formed by means of the well known sputtering or evaporation process. In Fig. 6, the conductive layer 151 connects the $n^+$ type drain region of the transistor $Q_n$ to the $p^+$ type load region which forms the leaky pn junction with the $n^-$ type silicon substrate 11. Lastly, the second insulating layer of PSG 16, which is also a protecting and passivating layer, is formed by means of CVD (Chemical Vapor Deposition), and the memory chip is completed.

As has been mentioned above, the CMIS device may be constructed on the $n^-$ type substrate. However, it should be noted that the CMIS device can also be constructed on a $p^-$ type substrate. In this case, p-channel type MIS transistors are formed on the surface of $n^-$ type well formed on the $p^-$ type substrate, n-channel type MIS transistors are formed on the surface of the $p^-$ type substrate, and $n^+$ type load regions are formed on the

$p^-$ type substrate.

In the above-mentioned embodiment, the CMIS memory device has been explained. However, it is also possible to adapt the present invention to the single channel type MIS device, such as an n-channel type MIS integrated circuit device. For example, as illustrated in Fig. 7, a $p^+$ type load region 23 is formed on n type well 22 which is formed on p type silicon substrate 21. The $p^+$ type load region 23 is connected to the gate electrode 24 of an n type MIS transistor $Q_n$ formed on the substrate 21 through conductive layer, which is illustrated diagrammatically by a connection line 25, made of aluminum. The positive voltage $V_{cc}$ is supplied to the p type silicon substrate 21. The pn junction composed by the p type substrate 21 and the n type well 22 is forward biased and the pn junction composed by the $p^+$ type load region 23 and n type well 22 is reverse biased. The pn junction composed by the $p^+$ type load region 23 and n type well 22 is made incomplete, i.e., leaky, and is used as the load element of the n type MIS transistor $Q_n$.

## CLAIMS

1. A semiconductor device comprising one or more driver transistors and one or more load elements each of which is connected to one of said driver transistors, respectively, characterized in that each of said driver transistors is composed of an MIS Field Effect transistor formed on a semiconductor substrate portion, and, at least one of said load elements is composed of a reverse biased pn junction which is formed on said semiconductor substrate portion.

2. A semiconductor device comprising one or more driver transistors and one or more load elements each of which is connected to one of said driver transistors, respectively, characterized in that each of said driver transistors is composed of an MIS Field Effect transistor formed on a first conductivity type semiconductor region which is formed on a second conductivity type semiconductor substrate portion, and, at least one of said load elements is composed of a reverse biased pn junction which is formed on said second conductivity type semiconductor substrate portion.

3. A semiconductor device as set forth in claim 2, wherein said semiconductor device is a CMIS device further comprising one or more MIS Field Effect transistors formed on said second conductivity type semiconductor substrate.

4. A semiconductor device as set forth in claim 2 or 3, wherein said first conductivity type semiconductor region is a p type semiconductor region and said second conductivity type semiconductor substrate is an n type semiconductor substrate.

5. A semiconductor device as set forth in claim 2 or 3, wherein said first conductivity type semiconductor region is an n type semiconductor region and said second conductivity type semiconductor substrate is a p type semiconductor substrate.

6. A semiconductor device as set forth in claim 4, wherein said pn junction is a leaky pn junction whose

0020113

backward current is relatively large.

7.    A semiconductor device as set forth in claim 5, wherein said pn junction is a leaky pn junction whose backward current is relatively large.

8.    A semiconductor device as set forth in claim 6, wherein said semiconductor device is a memory device having a plurality of memory cells, each of which comprises a pair of MIS Field Effect transistors formed on said first conductivity type semiconductor region and a pair of said pn junctions, the drain electrode of each one of said MIS transistors being connected to the gate electrode of the other one of said MIS transistors and to one of said pn junctions.

9.    A semiconductor device as set forth in claim 7, wherein said semiconductor device is a memory device having a plurality of memory cells, each of which comprises a pair of MIS transistors formed on said first conductivity type semiconductor region and a pair of said pn junctions, the drain electrode of each one of said MIS Field Effect transistors being connected to the gate electrode of the other one of said MIS transistors and to one of said pn junctions.

## Fig. 1

## Fig. 2

*Fig. 3*

*Fig. 4*

*Fig. 5*

*Fig. 6*

*Fig. 7*

European Patent
Office

**EUROPEAN SEARCH REPORT**

0020113

Application number

EP 80 30 1730

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| X | 1977 INTERNATIONAL ELECTRON DE-VICES MEETING, TECHNICAL DIGEST, 5,6,7 December 1977, pages 402-405 Washington D.C., U.S.A. L.G. WALKER et al.: "Four-transistor static CMOS memory cells"<br><br> * Figures 2-6; page 402: "Introduction"; page 403: "Processing of leaky diodes" *<br><br>-- | 1-9 | H 01 L 27/06<br>27/10<br>G 11 C 11/40 |
| X | IBM TECHNICAL DISCLOSURE BULLETIN, vol. 11, no. 10, March 1969, page 1218 New York, U.S.A. R.G. GLADU: "Use of a buried layer for low-power fet cells"<br><br> * Complete document *<br><br>-- | 1 | **TECHNICAL FIELDS SEARCHED (Int.Cl. 3)**<br><br>H 01 L 27/06<br>27/10<br>G 11 C 11/40 |
| | IBM TECHNICAL DISCLOSURE BULLETIN, vol. 13, no. 12, May 1971, pages 3614-3615 New York, U.S.A. F. GAENSSLEN: "Complementary four device fet memory cell"<br><br> * Complete document *<br><br>-- | 1-9 | |
| X | IBM TECHNICAL DISCLOSURE BULLETIN, vol. 11, no. 6, November 1968, pages 592-593 New York, U.S.A. R.H. DENNARD et al.: "Fet memory cell using diodes as load devices"<br><br> * Complete document *<br><br>--<br>./. | 1 | **CATEGORY OF CITED DOCUMENTS**<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

The present search report has been drawn up for all claims

| Place of search | Date of completion of the search | Examiner |
|---|---|---|
| The Hague | 15-09-1980 | CARDON |

EPO Form 1503.1 06.78

European Patent
Office

## DOCUMENTS CONSIDERED TO BE RELEVANT

| Category | Citation of document with indication, where appropriate, of relevant passages | Relevant to claim |
|---|---|---|
| | IBM TECHNICAL DISCLOSURE BULLETIN, vol. 13, no. 2, July 1970, pages 302-303 New York, U.S.A. F.H. GAENSSLEN et al.: "Fet memory cell using schottky diodes as load devices" <br><br> * Complete document * <br><br> ---- | 1 |

CLASSIFICATION OF THE
APPLICATION (Int. Cl. 3)

TECHNICAL FIELDS
SEARCHED (Int. Cl. 3)